# EUROPEAN PATENT SPECIFICATION

(11) **EP 3 300 886 B1**
(45) Date of publication and mention of the grant of the patent: **04.12.2019**
(21) Application number: 17192685.0
(22) Date of filing: 22.09.2017
(51) Int. Cl.: B41J 2/005, H05K 3/04, B05D 3/06, B05D 1/28, H05K 3/30, H05K 3/32, H05K 3/34

(54) **METHODS AND APPARATUS FOR PRINTING HIGH-VISCOSITY MATERIALS**
VERFAHREN UND VORRICHTUNG ZUM BEDRUCKEN VON HOCHVISKOSEN MATERIALIEN
PROCÉDÉS ET APPAREIL POUR L'IMPRESSION DE MATÉRIAUX À VISCOSITÉ ÉLEVÉE

(30) Priority: 28.09.2016 US 201662400635 P; 18.01.2017 US 201762447471 P
(43) Date of publication of application: 04.04.2018
(73) Proprietor: Orbotech Ltd., 8110101 Yavne (IL)
(72) Inventor: KOTLER, Zvi, Tel Aviv 6299516 (IL); ANKRI, Jonathan, Modiin 7170927 (IL)
(74) Representative: White, Duncan Rohan

(56) References cited:
- EP-A1- 2 151 282
- WO-A1-2016/116924
- US-A1- 2003 017 277

## Description

### FIELD OF THE INVENTION

The present invention relates generally to laser-induced material printing, and particularly to methods and systems for printing of high-viscosity materials.

### BACKGROUND OF THE INVENTION

Laser-Induced Forward Transfer (LIFT) technology offers an attractive cost/performance ratio for manufacturing and repairing Printed Circuit Boards (PCBs), Integrated Circuits (IC) substrates, Flat Panel Displays (FPDs) and other electronic devices. In the LIFT process laser photons are used for ejecting a volume of material from a source film (known as a "donor") toward an acceptor substrate (known as "acceptor" or "receiver").

US2003/017277 A1 discloses a method for laser transfer and deposition of a rheological fluid according to the preamble of claim 1 wherein laser energy strikes a target substrate comprising a rheological fluid, causing a portion of the rheological fluid to evaporate and propel a jet of the non-evaporated rheological fluid onto a receiving substrate.

WO 2016/116924 A1 discloses a method for 3D printing including printing a first metallic material on a substrate as a support structure and a second metallic material on the substrate as a target structure, in contact with the support structure. The support structure is chemically removed from the target structure by selective corrosion of the first metallic material.

### SUMMARY OF THE INVENTION

According to the present invention, there is provided a method for disposing material according to claim 1, including positioning a donor film including a donor material at a predefined distance from an acceptor substrate, the donor film facing toward the acceptor substrate. One or more pulses of laser radiation are directed to impinge on the donor film at a given location so as to induce formation of a protrusion made from the donor material. A distal tip of the protrusion touches the acceptor substrate and disposes thereon while the protrusion is still in contact with the donor film. A spot of the donor material is formed on the acceptor substrate by increasing a separation between the donor film and the acceptor substrate so as to detach the distal tip of the protrusion from the donor film.

In some embodiments, positioning the donor film at the predefined distance is carried out after directing the pulses of the laser radiation, and increasing the separation is carried out after the distal tip of the protrusion touches the acceptor substrate. In other embodiments, the method includes controlling an amount of the disposed donor material by controlling the predefined distance between the donor film and the acceptor substrate. In yet other embodiments, directing the pulses of the laser radiation includes setting at least one parameter of the laser pulses based on the predefined distance.

In an embodiment, the method includes disposing additional donor material on top of the disposed donor material at the given location by (i) re-positioning the donor film at the predefined distance without applying additional pulses of the laser radiation and (ii) increasing the separation between the donor film and the acceptor substrate again. In another embodiment, the method includes disposing on the acceptor substrate a contiguous pattern of the donor material, by performing one or more of: spatially shaping a beam of the laser radiation, and directing one or more additional pulses of the laser radiation to impinge on the donor film at a predefined spacing from the given location. In yet another embodiment, directing the pulses of the laser radiation includes scanning the laser radiation to impinge on the donor film at multiple points.

In some embodiments, directing the pulses of the laser radiation includes splitting the laser radiation to multiple beams that impinge on the donor film at multiple respective locations separated from one another. In other embodiments, the method includes, before finally disposing the protrusions on the acceptor substrate, forming the protrusions by (i) positioning an auxiliary substrate at a given distance from the donor film, (ii) shaping the protrusions by increasing a separation between the donor film and the auxiliary substrate and (iii) removing the auxiliary substrate. In yet other embodiments, the auxiliary substrate includes an allocated area of the acceptor substrate.

In an embodiment, the auxiliary substrate includes a substrate different from the acceptor substrate. In another embodiment, the donor material has an equivalent viscosity level higher than 10,000 centipoise at a temperature of 25°C. In yet another embodiment, directing the pulses of the laser radiation includes forming a geometrical pattern of spots on the acceptor substrate, by directing the pulses to multiple different locations on the donor film and inducing the formation of multiple protrusions at the multiple locations, and including, after forming the protrusions, printing the geometrical pattern by increasing a separation between the donor film and the acceptor substrate so as to detach distal tips of the protrusions from the donor film.

In some embodiments, the method includes repeating printing of the geometrical pattern without applying additional pulses of the laser radiation. In other embodiments, the donor material includes a given material whose viscosity decreases under shear stress. In yet other embodiments, the shear stress is caused by the one or more pulses of laser radiation impinging on the donor film.

In an embodiment, in response to removal of the shear stress, the viscosity level of the given material returns to its pre-stress level after a time delay between 100 microseconds and 100 milliseconds. In another embodiment, the given material includes a form selected from a list consisting of an ink, a paste, a gel, and dispersions comprising particles.

According to the present invention, there is also provided an apparatus for disposing material according to claim 12, the apparatus including a positioning assembly, an optical assembly and a control unit controlling the operation of the optical assembly and the positioning assembly. The positioning assembly is configured to position a donor film including a donor material at a predefined distance from an acceptor substrate, the donor film facing toward the acceptor substrate. The optical assembly is configured to generate one or more pulses of laser radiation and to direct the one or more pulses to impinge on the donor film at a given location so as to induce formation of a protrusion made from the donor material. A distal tip of the protrusion touches the acceptor substrate and disposes thereon while the protrusion is still in contact with the donor film. After forming the protrusion, the positioning assembly is configured to form a spot of the donor material on the acceptor substrate by increasing a separation between the donor film and the acceptor substrate so as to detach the distal tip of the protrusion from the donor film.

The present invention will be more fully understood from the following detailed description of the embodiments thereof, taken together with the drawings in which:

### BRIEF DESCRIPTION OF THE DRAWINGS

Fig. 1 is a schematic, pictorial illustration of a Laser-Induced Forward Transfer (LIFT) system for printing on a substrate, in accordance with an embodiment of the present invention;
Fig. 2 is a schematic, sectional view showing steps of a process for printing viscous materials using LIFT techniques, in accordance with an embodiment of the present invention;
Fig. 3 is a flow chart that schematically illustrates a method for printing viscous materials using LIFT techniques, in accordance with an embodiment of the present invention;
Fig. 4 is a schematic, sectional view showing steps of a process for assisting printing of viscous materials using a sacrificial substrate, in accordance with another embodiment of the present invention; and
Fig. 5 is a schematic, pictorial illustration of experimental results of printing a matrix of viscous materials using LIFT techniques, in accordance with an embodiment of the present invention.

### DETAILED DESCRIPTION OF EMBODIMENTS

### OVERVIEW

Embodiments of the present invention that are described hereinbelow provide improved methods and apparatus for depositing materials using Laser-Induced Forward Transfer (LIFT) techniques. Although the embodiments described herein refer mainly to materials having high viscosity, the disclosed techniques are applicable to a wide variety of materials and applications. In the description that follows, for the sake of clarity, the terms "printing", "depositing" and "disposing" are used interchangeably.

High viscosity materials, which are often (although not necessarily) defined as materials having a viscosity level higher than 10,000 centipoise (CPS) at a temperature of 25°C, are used in various applications such as adhesives in the production of electronic devices. In principle, high-viscosity materials may be printed on a substrate using dispensing techniques or stencil printing. Such techniques, however, are typically limited to printing dots larger than 200 µm in diameter. Furthermore, such techniques are typically limited to a printing rate of about 300 dots per second or less, depending on the viscosity of the materials used.

In some electronic devices, such as mobile devices, small form factor and low weight are important requirements. In printing viscous materials, such as metal pastes, electrically conductive adhesives (ECA), Nonconductive adhesives (NCA) or solder pastes (SP), under such requirements, it is important that the target dot diameter be smaller than 200 µm, and preferably smaller than 100 µm.

In some embodiments, a donor film made from one or more types of viscous materials such as ECA, NCA or SP, is formed on a donor substrate. In an embodiment, the donor film is positioned at a predefined distance (e.g., 1 mm) from an acceptor substrate, such as a flat panel display (FPD), a printed circuit board (PCB), or an integrated circuit (IC) substrate so that the viscous material of the donor film is facing the acceptor substrate.

In some embodiments, a laser source, such as a diode laser, is configured to irradiate laser pulses of 915 nm wavelength at a power of 150 Watts and a pulse width of 1-10 microseconds. The laser pulses are directed to impinge on the donor film at one or more predefined locations. The high energy conveyed in the laser pulses causes the viscous material of the donor film at the impinging locations and in proximity to the donor substrate, to vaporize. The local, transient pressure which forms drives the formation of a protrusion made from the viscous donor material, which extends out of the donor film towards the acceptor substrate.

In some embodiments, the donor film is moved towards the acceptor substrate until the distal tips of the protrusions touch the surface of the acceptor substrate, while still also connected to the donor film. The donor film is then moved away from the acceptor substrate so that the protrusions are torn from the donor film, thereby printing viscous material from the distal tips of the protrusions on the acceptor substrate. (By way of example, the description above refers to a moving donor and a stationary acceptor. Alternatively, the distance between the donor and acceptor can be changed by moving the acceptor and retaining the donor stationary, or by moving both.)

In some embodiments, the amount of donor material that will be printed on the acceptor substrate is determined by the difference between the maximal length of the induced protrusion (as obtained when the acceptor substrate is positioned at a sufficiently large distance from the donor film so that the protrusion cannot touch the acceptor substrate) and the minimal distance set between the donor film and the acceptor substrate. In these embodiments, as long as the distance between the donor film and an upper surface of the acceptor substrate exceeds the maximal length of the protrusion, no donor material will be printed on the acceptor substrate.

To print a spot smaller than 100 µm on the acceptor substrate, after forming the protrusion, the donor film may be positioned at a distance slightly smaller than the maximal length of the protrusion from the acceptor substrate, and then retracted so as to print the spot.

In some embodiments, a viscous material may be printed on the acceptor substrate to form printed dots having desired three-dimensional (3D) shapes. For example, a 3D structure such a pillar may be printed on the acceptor substrate by repeating the printing sequence described above multiple times, without horizontally moving the donor film or the acceptor substrate. In this embodiment, each application of the sequence forms an additional layer of the viscous material on top of the already formed pillar, thus enabling the formation of tall and narrow pillars, also known as high aspect ratio (HAR) pillars.

In some embodiments, the disclosed techniques may be used to print lines or other elongated patterns of the viscous material, not only dots. Printing of patterns can be performed, for example, by shaping the laser beam to have the desired spatial pattern, and/or by printing a series of partially-overlapping dots of viscous material by moving the laser beam over the donor film.

In some embodiments, a sacrificial substrate may be used to shape the cross sections of the protrusions. For example, in some cases the actual cross sections of the protrusions as formed have different dimensions than planned. In such cases, the sacrificial substrate may be pressed against the distal tips of the protrusions and pulled away from the donor film in a controlled manner so as to shape the protrusions to the desired dimensions. Then, the shaped protrusions are applied to the actual acceptor substrate for printing.

The disclosed printing techniques can be used for producing various devices, such as hand held devices, mobile phones, internet-of-things (loT) devices or other mobile devices, or any suitable devices having small form factor and low weight. Furthermore, by using the disclosed techniques, significant cost reduction in producing such devices is possible due to increased printing rate by a factor of ten.

### SYSTEM DESCRIPTION

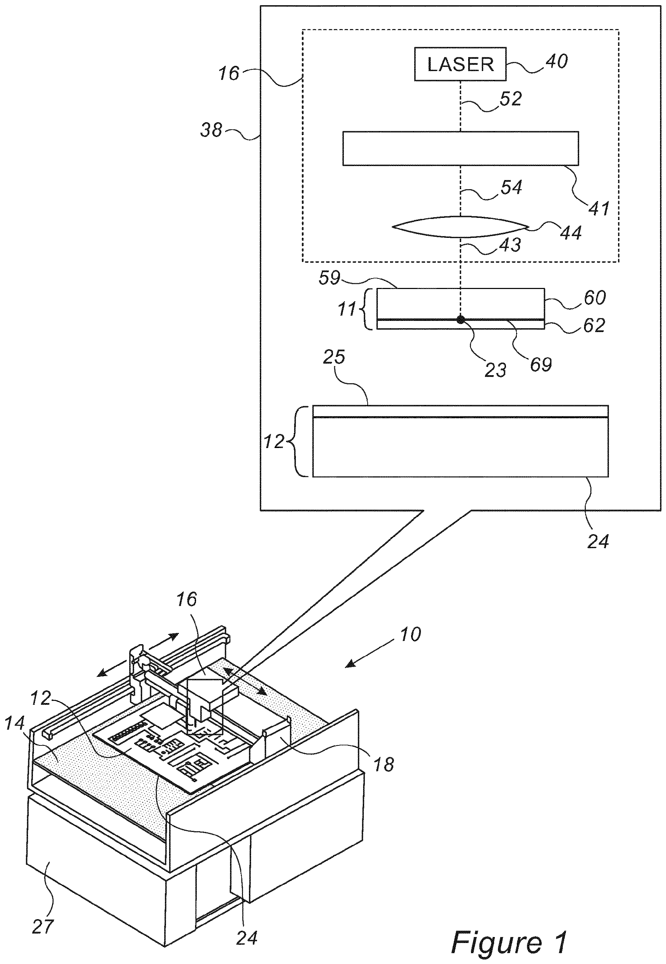

Fig. 1 is a schematic, pictorial illustration of a laser-induced forward transfer (LIFT) system 10, in accordance with an embodiment of the present invention.

In some embodiments, system 10 is configured to print various materials on a substrate 24 of an electronic circuit, referred to herein as acceptor board 12, such as a flat panel display (FPD), a printed circuit board (PCB) or an integrated circuit (IC) substrate, which is held on a mounting surface 14. In LIFT processes, board 12 is also referred to herein as a "receiver" or an "acceptor." The terms "Flat panel Display," "FPD," "printed circuit board," "PCB," "integrated circuit substrate," and "IC substrate" are used herein to refer generally to any suitable substrate on which materials are deposited.

In some embodiments, system 10 is configured to deposit materials having equivalent viscosity level higher than 10,000 centipoise (CPS) at a temperature of 25°C, such as adhesive materials, electrically conductive adhesives (ECA), Nonconductive adhesives (NCA), solder pastes (SP) or metal pastes (nanoparticle or micro-particle metal pastes) or dielectric pastes. Generally, however, the disclosed techniques are not limited to any particular material.

In an embodiment, system 10 comprises a positioning assembly 18, which is configured to position an optical assembly 16 over desired sites of substrate 24, by moving optical assembly 16 linearly along selected axes of system 10. In some embodiments, positioning assembly 18 may comprise a moving bridge configured to move along one or more axes, e.g., horizontal axes X, Y, and a vertical axis Z. In other embodiments, positioning assembly 18 may comprise a moving stage. Alternatively, other suitable techniques can be used to move positioning assembly 18 and board 12 relative to one another. A control unit 27 controls several functionalities of system 10, such as the operation of optical assembly 16 and positioning assembly 18.

Control unit 27 typically comprises a general-purpose computer, which is programmed in software to carry out the functions described herein. The software may be downloaded to the computer in electronic form, over a network, for example, or it may, alternatively or additionally, be provided and/or stored on non-transitory tangible media, such as magnetic, optical, or electronic memory.

Reference is now made to an inset 38, which is a schematic side view capturing optical assembly 16, a donor 11, and board 12.

In some embodiments, optical assembly 16 comprises a laser 40, such as a high power fiber coupled diode laser (HPFCDL) product K915FG2RN-150.0W made by BWT Beijing Ltd (2nd FI, No.4A Hangfeng Rd. Fengtai Beijing 100070, China), or a similar product made by nLight Corporation, Vancouver, Washington 98665, or by any other supplier of such lasers.

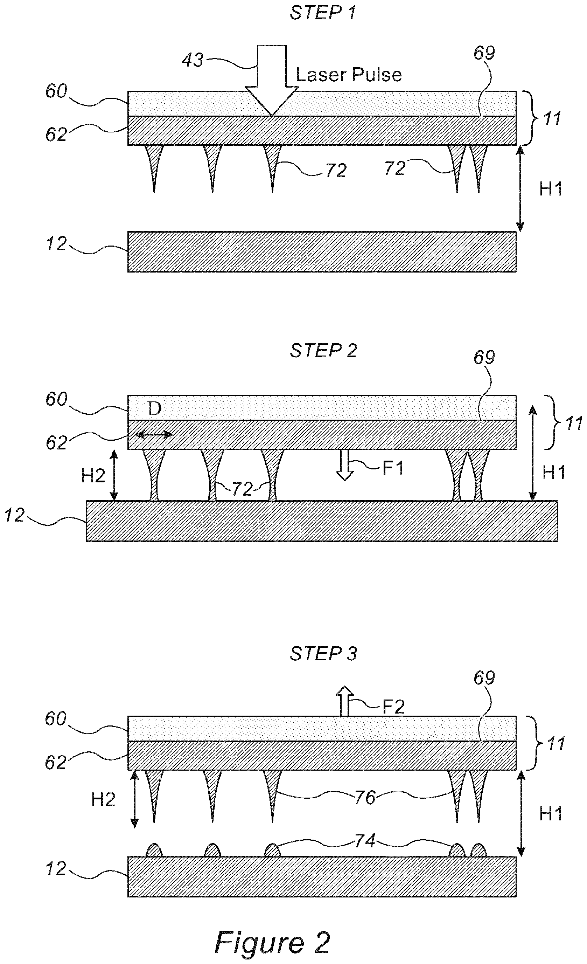

In an embodiment, laser 40 may emit a pulsed beam 52 at a 915 nm wavelength and power of 150 W, or any other suitable wavelength and power level. In some embodiments, the pulses generated by laser 40 may have a pulse width of 1-10 microseconds, so as to irradiate donor 11 at energy levels of 150 µJ to 1.5 mJ. Such an energy level enables the formation of protrusions of the donor material from a donor film 62 as will be depicted in detail in Fig. 2 below.

In an embodiment, a beam scanning assembly 41 manipulates beam 52 into one or more beams 54 that are focused through optics 44 so as to form one or more beams 43, e.g., by splitting beam 43 into multiple sub-beams. In an embodiment, donor 11 comprises a substrate 60, typically made from an optically transparent material, such as a glass or plastic sheet. Optics 44 focuses each beam 43 through a top surface 59 of substrate 60 to impinge a surface 69 of donor film 62 at a desired location, such as a location 23.

In some embodiments, beam 43 induces formation of the viscous material to be ejected as protrusions from film 62 onto board 12.

In some embodiments, beam scanning assembly 41 further comprises a scanner (not shown) having a suitable scanning mechanism, such as galvo mirrors, which scans beams 43 so as to induce the formation of the protrusions depicted in Fig. 2 at a frequency rate higher than 3 KHz or any other suitable rate.

In an embodiment, the scanner of beam scanning assembly 41 is configured to scan beam 43 on surface 69 so as to induce the formation of thousands of protrusions per second, thus, disposing the donor material on acceptor board 12 at a substantially similar printing rate.

In some embodiments, the scanner of beam scanning assembly 41 is configured to direct beams 43 to location 23 at a typical positioning accuracy of less than 5 µm. In an embodiment, a typical distance between donor 11 and board 12 is on the order of 1 mm or larger. At this distance, positioning assembly 18 is configured to position optical assembly 16 and donor 11 relative to board 12 at a typical positioning accuracy of less than 10 µm. Therefore, the total positioning accuracy of system 10 supports printing the material of film 62 on board 12 at a typical accuracy of 10 µm - 20 µm. The printing accuracy may be further improved using any other suitable scanning and positioning assemblies.

In some embodiments, beam 43 may form a spherically symmetric spot at location 23, thereby inducing formation of a corresponding spherically symmetric protrusion.

In other embodiments, optical assembly 16 is configured to shape beam 43 to a contiguous cross section, such as a linear cross section, so as to induce formation of contiguous protrusions such as lines or curved line segments on board 12.

In another embodiment, optical assembly 16 is further configured to split beam 43 into multiple sub-beams and to direct multiple pulses of the multiple sub-beams of beam 43 to impinge on surface 69 at multiple locations with close proximity to one another so as to induce the formation of contiguous protrusions that enable printing on board 12 a contiguous pattern.

In yet another embodiment, after printing a first pattern at a given location (e.g., location 23) on board 12, positioning assembly 18 is further configured to reposition optical assembly 16 and donor 11 relative to board 12, so as to print an additional layer on the same pattern at location 23, or to print a second pattern in close proximity to the first pattern. Additional embodiments for printing are depicted in Figs. 2-5 below.

In other embodiments, system 20 may comprise any other suitable type of laser 40, such as a continuous-wave (CW) modulated laser, a quasi-CW fiber laser, or a pulsed fiber laser having a range of pulse widths between a few nanoseconds and a few hundreds of nanoseconds (e.g., YAG-based or Ytterbium-based fiber laser). Such lasers are produced, for example, by IPG photonics or Spectra-Physics.

The disclosed configuration of system 10 and its components are depicted here by way of example, so as to illustrate the sort of environment in which the techniques described herein may be implemented. Such techniques may similarly be carried out using and any other suitable equipment and configurations.

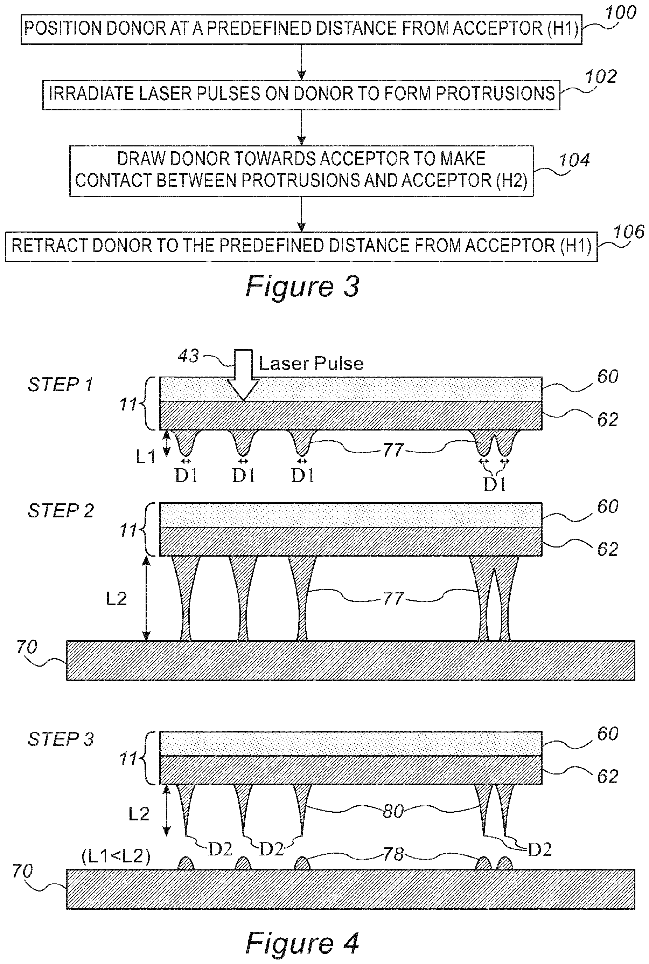

Fig. 2 is a schematic sectional view showing a multi-step process for printing viscous materials using system 10, in accordance with an embodiment of the present invention. The process depicted in Fig. 3 is broken into three steps purely for the sake of conceptual clarity.

Reference is now made to a step 1. In some embodiments, positioning assembly 18 positions film 62 of donor 11 at a distance denoted H1 (e.g., 2 mm or 3 mm) from acceptor board 12. In an embodiment, film 62 comprises one or more materials having equivalent viscosity level higher than 10,000 CPS at a temperature of 25°C, such as metallic pastes, adhesive materials, ECA, NCA, and SP, as described in Fig. 1 above. The materials comprising film 62 are pre-coated on substrate 60 using any suitable deposition techniques known in the art. In an embodiment, optical assembly 16 directs beam 43 to impinge on film 62 at one or more predefined locations, such as location 23 (in Fig. 1).

In some embodiments, the interaction between beam 43 and film 62 heats the viscous material of film 62 at the interface with substrate 60 at the impinging locations. In an embodiment, the excess heat causes the formation of one or more hot bubbles of gas (not shown) at the interface. The gas in the bubbles applies pressure on film 62 at the impinging locations, thereby forms protrusions 72 that extend out of film 62 toward acceptor board 12.

In some embodiments, film 62 comprises materials of non-Newtonian viscosity (e.g., fluid materials not obeying Newton's law of viscosity). The viscosity of such materials decreases (typically in a substantial amount) in the presence of a fast shear stress induced, for example, by the interaction between beam 43 and film 62. The phenomena of viscosity reduction in the presence of shear stress is also referred to herein as "shear thinning." The viscosity of such materials typically returns to its initial value (i.e., before applying the shear stress) after removing the shear stress.

In the example of step 1, when beam 43 impinges on film 62, the shear thinning of film 62 at the impinging location induces the extension of protrusion 72 out of film 62 toward substrate 12. After beam 43 is removed from the impinging location, the viscosity of the material increases, thereby reducing the progress of the extension of protrusion 72 to a complete stop, which determines the dimensions (e.g., length) of protrusion 72 as shown in step 1.

In these embodiments, the length of protrusion 72 depends on the characteristics of beam 43 (e.g., power and pulse width of the beam) and on properties of the non-Newtonian viscous materials comprising film 62. For example, non-Newtonian viscous materials having high initial viscosity (e.g., viscosity level higher than 10,000 CPS) may exhibit minor shear thinning in the presence of a shear stress.

In some embodiments, the shear thinning property of some materials having non-Newtonian viscosity may be time-dependent (also referred to herein as "thixotropic"), such that after removing the shear stress, the viscosity returns to its initial value only after some time delay, rather than immediately. This time delay is referred to herein as "recovery time" of the viscosity.

In some embodiments, the recovery time of a selected non-Newtonian viscous material is required to be shorter than the total time it takes protrusion 72 to reach its specified length. In other words, the recovery time has to be shorter than the ratio L/v, wherein L is the specified length of protrusion 72, and v is an average progression velocity of protrusion 72. The inventors found that typical values of required recovery time of suitable non-Newtonian viscous materials, are on the order of 100 microseconds to 10's of milliseconds (e.g., 100 milliseconds,) so as to control the specified length and shape of protrusion 72 in the configuration described in Fig. 1 above.

In some embodiments, the properties of such non-Newtonian viscous materials can be controlled by using suitable additives, such as organic molecules and particles, or by controlling the acidity level (PH) of these materials, or by selecting polymers having predefined molecular weights. Furthermore, various dispersions comprising nanoparticles (silica or otherwise metals) show enhanced shear thinning and can be accompanied with fast recovery.

In some embodiments, the materials having non-Newtonian viscosity may appear in various suitable forms, such as but not limited to a form of, an ink, a paste, a gel, and dispersions comprising micro-particles and/or nano-particle at a volumetric content that exceeds 20% of the total volume of the material. These materials comprising film 62 are pre-coated on substrate 60 using any suitable deposition techniques known in the art.

Reference is now made to a step 2. In an embodiment, positioning assembly 18 moves donor 11 in a direction denoted F1 towards board 12, and positions donor 11 so that film 62 is at a distance H2 (e.g., 0.1mm) from board 12, smaller than H1, so as to make a physical contact between the distal tips of protrusions 72 and the top surface of board 12. Note that at step 2, the proximal ends of protrusions 72 are still in contact with film 62, and the distal tips of protrusions 72 are touching acceptor board 12.

In some embodiments, the proximal end of each protrusion 72 is wider than its distal tip. The diameter of the proximal end of protrusion 72 at the surface of film 62 is denoted D, (in case of a symmetrically round protrusion.) The diameter of the distal tip of protrusion 72 is typically substantially smaller than diameter D, typically on the order of a few tens of microns.

Reference is now made to a step 3. In some embodiments, positioning assembly 18 moves donor 11 in a direction denoted F2 away from board 12, so as to reposition film 62 at distance H1 from board 12 (or any other suitable distance). In an embodiment, an adhesion force between the distal tips of protrusions 72 and board 12 causes protrusions 72 to split into traces 74 disposed on board 12, and proximal ends 76 that remains attached to the surface of film 62.

In some embodiments, the amount of material printed on board 12, which may indicate the dimensions of traces 74 printed on board 12, may be controlled in various ways. In principle, the amount of material printed using the three-step process depicted in Fig. 2 may be determined by the ratio between the estimated maximal achievable length of protrusion 72 (without having board 12 as a stopper) and the distance between donor 11 and acceptor board 12.

In an embodiment, the total energy of beam 43 may be controlled by controlling the power of laser 40, and/or by controlling the pulse width of beam 52. Impinging a higher-energy beam 43 on film 62 effectively increases the maximal length of protrusion 72, resulting in a larger dimension of trace 74 (assuming the same distance H2). In another embodiment, a larger trace 74 may be obtained by setting a smaller distance H2 between donor 11 and acceptor board 12.

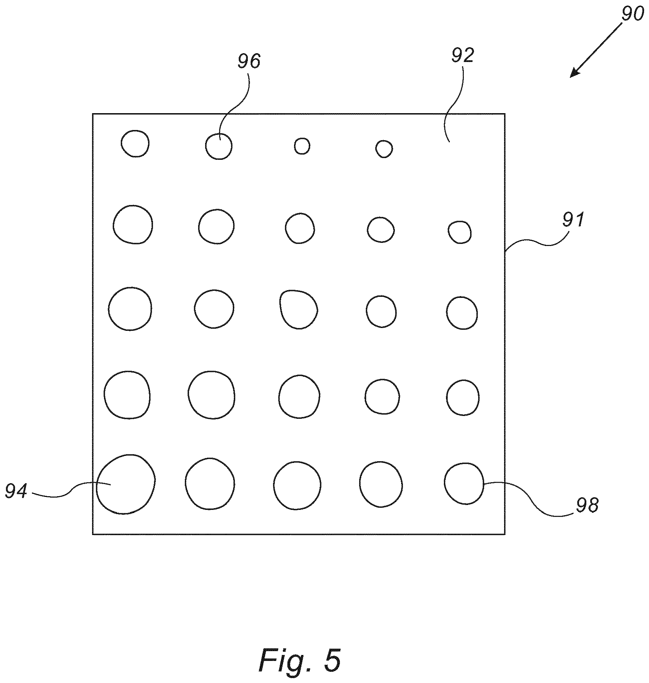

The embodiments related to controlling the dimensions of the printed traces, such as trace 74, are further described in Fig. 5 below.

In some embodiments, repeating the three-step process depicted in Fig. 2 enables printing multiple layers of trace 74, on top of one another. In this embodiment, in each repetition of this sequence an additional layer of trace 74 is printed on top of the trace previously printed at the same location on board 12. For example, five repetitions of the sequence may result in printing a three-dimensional (3D) pillar made from five traces 74 stacked vertically. Furthermore, since this embodiment does not require moving positioning assembly 18 laterally, the method supports fast printing of 3D patterns on board 12 at a printing rate of several thousands of traces per second.

Furthermore, since lateral movement of positioning assembly 18 is not required, the positioning accuracy of each trace 74 layer depends solely on the positioning accuracy of the scanner of beam scanning assembly 41, which typically has a positioning error lower than 5 µm. In other embodiments, after completing the printing of trace 74, protrusion 76 is still usable, and system 20 is configured to print the 3D pillar by repeating only steps 2 and 3, without reapplying beam 43 on film 62. In this embodiment, the positioning error of the scanner is eliminated, and therefore, the positioning accuracy of the stacked traces is further improved. This positioning accuracy enables printing tall and narrow pillars (i.e., high aspect ratio pillars, as defined below) made from multiple traces 74 stacked on top of one another. The ratio between the height and the diameter of the pillar is referred to herein as an "aspect ratio." An aspect ratio that is considered as a high aspect ratio (HAR), is substantially larger than 1.

The improved positioning accuracy enables constructing HAR 3D features, by vertically stacking a large number of round traces of small diameter (or having any other suitable shape).

In alternative embodiments, donor 11 is static and at step 2, positioning assembly 18 moves board 12 up, i.e., towards donor 11 to make the contact between protrusions 76 and board 12, and thereafter, at step 3, positioning assembly 18 retracts board 12 away from donor 11 so as to print traces 74 on board 12.

Fig. 3 is a flow chart that schematically illustrates a method for printing viscous materials using LIFT techniques, in accordance with an embodiment of the present invention. The method begins with positioning assembly 18 positioning donor 11 so that film 62 is at a predefined distance H1 from acceptor board 12, at a donor positioning step 100.

At a protrusions formation step 102, laser 40 irradiates beam 43 that impinges on film 62 at desired locations, such as location 23, so as to form protrusions 72. In an embodiment, beam scanning assembly 41 is configured to scan beam 43 over surface 69 at thousands locations so that beam 43 impinges on surface 69 at the corresponding locations (such as location 23) separated from one another, so as to form thousands protrusions 72 without requiring to move donor 11 along horizontal axes X, Y. At a donor drawing step 104, positioning assembly 18 draws donor 11, so as to set distance H2 between film 62 of donor 11 and board 12, and to make physical contact between protrusions 72 and board 12. At a retraction step 106 that concludes the method, positioning assembly 18 retracts donor 11 away from board 12, so as to print traces 74 on board 12.

In some embodiments, the method may loop back to donor drawing step 104 so as to begin a subsequent printing cycle in which another layer of traces is printed on top of traces 74 without applying additional pulses of beams 43 on surface 69.

In other embodiments, the method may loop back to protrusions formation step 102 so as to begin a subsequent printing cycle in which another layer of traces is printed on top of traces 74 by scanning beam 43 to apply pulses at location 23 on the donor. In an embodiment, repeating the method depicted in Fig. 3 multiple times (with or without reapplying beam 43) enables the formation of HAR 3D pillars, as described in Fig. 2 above.

Fig. 4 is a schematic, sectional view showing a three-step process for assisting printing of viscous materials using a sacrificial substrate 70, in accordance with embodiments of the present invention. Fig. 4 depicts a sequence of three process steps purely for the sake of conceptual clarity. In practice, the sequence may comprise more than three steps as well as sub-steps, or fewer step.

Reference is now made to a step 1. In some embodiments, beam 43 impinges on film 62 and induces formation of protrusions 77. In the example of step 1, protrusions 77 have a typical length denoted L1, and their distal tips have a typical diameter denoted D1. L1 is shorter than a desired length L2 (shown in step 2), and D1 is wider than a desired diameter D2 of the distal tips (shown in step 2). In an embodiment, the diameter (or width) of the distal tips of protrusions 77 typically determines the printed diameter of the dots, such as traces 74.

In the present example, L1 is smaller than 0.1 mm and D1 is wider than 50 µm, which are the required values for carrying out the desired printing process of the viscous material of film 62.

The unsuitable length L1 and/or diameter D1 may be due, for example, to insufficient energy of beam 43, to an exceedingly high viscosity of the material comprising film 62, the rheological behavior of the material of film 62 under fast shearing rate under the impact of beam 43, or to any other reason.

Reference is now made to step 2. In some embodiments, positioning assembly 18 positions an auxiliary substrate (referred to herein as a sacrificial substrate) such as a blank substrate 70, below donor 11. In an embodiment, positioning assembly 18 moves donor 11 towards substrate 70 so that the distal tips of protrusions 77 make contact with the upper surface of substrate 70. Then, positioning assembly 18 retracts substrate 70 away from donor 11 in a controlled manner, so that an adhesion force between the distal tips of protrusions 77 and substrate 70 enables shaping the length and width of protrusions 77.

Reference is now made to a step 3. In some embodiments, the retraction of substrate 70 and the adhesion force between the distal tips of protrusions 77 and substrate 70 cause protrusions 77 to split into traces 78 disposed on substrate 70, and to shape proximal ends 80 to length L2 and diameter D2, which are the desired shape to resume the printing process.

In an embodiment, after shaping proximal ends 80, substrate 70 is removed from system 10 by positioning assembly 18 (or alternatively by an operator) and replaced by acceptor board 12 of Fig. 2 above. In an embodiment, positioning assembly 18 moves donor 11 towards board 12 to a distance smaller than L2 so that the top surface of board 12 makes contact with the distal tips of proximal ends 80, and then retracts donor 11 away from board 12 in a controllable manner so as to print a trace, such as trace 74 of Fig. 2 above. (These intermediate steps are not shown in Fig. 4, but a substantially similar operation was already described above in steps 2 and 3 of Fig. 2.) Note that, as depicted in steps 2 and 3, shaping the length of the protrusions from L1 to L2 and the diameter of their distal tips, from D1 to D2 enables printing on acceptor board 12 dots, such as traces 74, at a desired diameter smaller than 50 µm.

In an alternative embodiment, steps 2 and 3 may be carried out on a designated location on board 12, instead of using a dedicated sacrificial substrate 70. In other words, a certain area on acceptor board 12 can be allocated to serve as a sacrificial area. This embodiment eliminates the need to use substrate 70.

In some embodiments, after step 3 donor 11 and an array of protrusions 80 may be used as a template pattern for printing. In an embodiment, one or more HAR 3D pillars may be produced, for example, by repeating the printing process on board 12 as described above, multiple times at a predefined location. In another embodiment, the template pattern may be printed at multiple locations (other than the predefined location) by carrying out the printing process on board 12 at each of these multiple locations. In this embodiment, positioning assembly 18 moves donor 11 along horizontal axes X, Y to one of the multiple locations. After positioning donor 11 at the desired location, positioning assembly 18 moves donor 11 (e.g., along the Z axis) towards board 12 to make contact with protrusions 80, followed by retracting donor 11 away from board 12 as described above. By repeating this move (along X, Y axes) and print sequence at least once at each of the multiple locations, system 10 may print the template pattern of step 3 at these multiple locations.

Fig. 5 is a schematic, pictorial illustration of experimental results of printing a matrix 90 of viscous materials using LIFT techniques, in accordance with an embodiment of the present invention. In some embodiments, matrix 90 comprises a substrate 91 that is positioned in system 10 having its top surface facing a donor film, such as donor film 62 shown in Figs. 2 and 4 above. In the present example experiment, system 10 was configured to induce a series of protrusions (not shown) for printing a matrix of dots on substrate 91. The donor film and the acceptor substrate were not parallel to one another, i.e., the distance between them is not constant, hence the different dot sizes. The terms "trace" and "dot" are used herein interchangeably.

The dots printed on substrate 91 had a minimal size substantially smaller than 100 µm and a maximal size larger than 100 µm. In the example of matrix 90, the distance between the donor and the acceptor substrate (denoted herein as "H") increases as we go from the lower left corner to the upper right corner on matrix 90. For example, the minimal distance at the lower left corner is 0.1 mm, and the maximal distance at the upper right corner (marked 92) is about 0.2 mm. Three example dots are denoted 94, 96 and 98 in the figure, having diameters of 115 µm, 55 µm, and 82 µm, respectively.

The experimental results of Fig. 5 demonstrate how the printed dot size can be controlled by setting the distance between facing surfaces of the donor and acceptor substrates. As noted above, similar results could be obtained with the donor film parallel to the acceptor substrate, and the length of the protrusions (denoted herein as "L") set by tuning the energy of beam 43. In some embodiments, the ratio between H and L determines the size (e.g., diameter) of the printed dot/trace. When the value of H is smaller than the value of L, the larger the ratio L/H the larger the size of the printed dot. When the value of H is larger than the value of L, no dot is printed.

It will thus be appreciated that the embodiments described above are cited by way of example, and that the present invention is not limited to what has been particularly shown and described hereinabove.

## Claims

1. A method for disposing material, comprising:
positioning a donor film (62) comprising a donor material (11) at a predefined distance from an acceptor substrate (12), wherein the donor film (62) is facing toward the acceptor substrate (12);
directing one or more pulses of laser radiation to impinge on the donor film (62) at a given location so as to induce formation of a protrusion (72) made from the donor material (11), wherein a distal tip of the protrusion (72) touches the acceptor substrate (12) and disposes thereon while the protrusion (72) is still in contact with the donor film (62); and **characterized by** also comprising:
forming a spot of the donor material (11) on the acceptor substrate (12) by increasing a separation between the donor film (62) and the acceptor substrate (12) so as to detach the distal tip of the protrusion (72) from the donor film (62).

2. The method according to claim 1, wherein positioning the donor film (62) at the predefined distance is carried out after directing the pulses of the laser radiation, and wherein increasing the separation is carried out after the distal tip of the protrusion (72) touches the acceptor substrate (12).

3. The method according to claim 1 or 2, and comprising controlling an amount of the disposed donor material (11) by controlling the predefined distance between the donor film (62) and the acceptor substrate (12).

4. The method according to claim 1, 2 or 3, wherein directing the pulses of the laser radiation comprises setting at least one parameter of the laser pulses based on the predefined distance.

5. The method according to any one preceding claim, and comprising disposing additional donor material (11) on top of the disposed donor material (11) at the given location by (i) re-positioning the donor film (62) at the predefined distance without applying additional pulses of the laser radiation and (ii) increasing the separation between the donor film (62) and the acceptor substrate (12) again.

6. The method according to any one preceding claim, and comprising disposing on the acceptor substrate (12) a contiguous pattern of the donor material (11), by performing one or more of:
spatially shaping a beam (43) of the laser radiation; and
directing one or more additional pulses of the laser radiation to impinge on the donor film (62) at a predefined spacing from the given location.

7. The method according to any one preceding claim, wherein directing the pulses of the laser radiation comprises:
scanning the laser radiation to impinge on the donor film (62) at multiple points, or
splitting the laser radiation to multiple beams (43) that impinge on the donor film (62) at multiple respective locations separated from one another.

8. The method according to any one preceding claim, and comprising, before finally disposing the protrusions (72) on the acceptor substrate (12), forming the protrusions (72) by (i) positioning an auxiliary substrate (70) at a given distance from the donor film (62), (ii) shaping the protrusions (72) by increasing a separation between the donor film (62) and the auxiliary substrate (70) and (iii) removing the auxiliary substrate (70), optionally the auxiliary substrate (70) comprises an allocated area of the acceptor substrate (12), further optionally the auxiliary substrate (70) comprises a substrate different from the acceptor substrate (12).

9. The method according to any one preceding claim, wherein the donor material (11) has an equivalent viscosity level higher than 10,000 centipoise at a temperature of 25°C.

10. The method according to any one preceding claim, wherein directing the pulses of the laser radiation comprises forming a geometrical pattern of spots on the acceptor substrate (12), by directing the pulses to multiple different locations on the donor film (62) and inducing the formation of multiple protrusions (72) at the multiple locations, and comprising, after forming the protrusions (72), printing the geometrical pattern by increasing a separation between the donor film (62) and the acceptor substrate (12) so as to detach distal tips of the protrusions (72) from the donor film (62), optionally repeating printing of the geometrical pattern without applying additional pulses of the laser radiation.

11. The method according to any one preceding claim, wherein the donor material (11) comprises a given material whose viscosity decreases under shear stress, optionally the shear stress is caused by the one or more pulses of laser radiation impinging on the donor film (62), further optionally in response to removal of the shear stress, the viscosity level of the given material returns to its pre-stress level after a time delay between 100 microseconds and 100 milliseconds, still further optionally the given material comprises a form selected from a list consisting of an ink, a paste, a gel, and dispersions comprising particles.

12. An apparatus for disposing material, the apparatus comprising a positioning assembly, an optical assembly and a control unit (27) controlling the operation of the optical assembly (16) and the positioning assembly (18) according to the method of claim 1 so that:
the positioning assembly (18) is configured to position a donor film (62) comprising a donor material (11) at a predefined distance from an acceptor substrate (12), wherein the donor film (62) is facing toward the acceptor substrate (12); and
the optical assembly (16) is configured to generate one or more pulses of laser radiation and to direct the one or more pulses to impinge on the donor film (62) at a given location so as to induce formation of a protrusion (72) made from the donor material (11), wherein a distal tip of the protrusion (72) touches the acceptor substrate (12) and disposes thereon while the protrusion (72) is still in contact with the donor film (62),
wherein, after forming the protrusion (72), the positioning assembly (18) is configured to form a spot of the donor material (11) on the acceptor substrate (12) by increasing a separation between the donor film (62) and the acceptor substrate (12) so as to detach the distal tip of the protrusion (72) from the donor film (62).

13. The apparatus according to claim 12, wherein the positioning assembly (18) is configured to position the donor film (62) at the predefined distance after directing the pulses of the laser radiation, and to increase the separation after the distal tip of the protrusion (72) touches the acceptor substrate (12).

14. The apparatus according to claim 12 or 13, wherein the positioning assembly (18) is configured to control an amount of the disposed donor material (11) by controlling the predefined distance between the donor film (62) and the acceptor substrate (12).

15. The apparatus according to claim 12, 13, or 14, wherein the optical assembly (16) is configured to set at least one parameter of the laser pulses based on the predefined distance.

## Patentansprüche

1. Verfahren zum Absetzen von Material, wobei das Verfahren Folgendes umfasst:
Anordnen einer Spenderfolie (62), die ein Spendermaterial (11) umfasst, bei einer vorbestimmten Entfernung von einem Empfängersubstrat (12), wobei die Spenderfolie (62) zu dem Empfängersubstrat (12) hin zeigt,
Richten eines oder mehrerer Impulse einer Laserstrahlung, so dass sie an einer gegebenen Position auf die Spenderfolie (62) auftreffen, um so die Bildung eines Vorsprungs (72) zu veranlassen, der aus dem Spendermaterial (11) hergestellt ist, wobei eine distale Spitze des Vorsprungs (72) das Empfängersubstrat (12) berührt und sich auf demselben absetzt, während sich der Vorsprung (72) noch in Berührung mit der Spenderfolie (62) befindet, und
**dadurch gekennzeichnet, dass** es ebenfalls Folgendes umfasst:
Bilden eines Punkts des Spendermaterials (11) auf dem Empfängersubstrat (12) durch Steigern eines Abstandes zwischen der Spenderfolie (62) und dem Empfängersubstrat (12), um so die distale Spitze des Vorsprungs (72) von der Spenderfolie (62) zu lösen.

2. Verfahren nach Anspruch 1, wobei das Anordnen der Spenderfolie (62) bei der vorbestimmten Entfernung nach dem Richten der Impulse der Laserstrahlung ausgeführt wird und wobei das Steigern des Abstandes ausgeführt wird, nachdem die distale Spitze des Vorsprungs (72) das Empfängersubstrat (12) berührt.

3. Verfahren nach Anspruch 1 oder 2 und welches das Steuern einer Menge des abgesetzten Spendermaterials (11) durch Steuern des vorbestimmten Abstandes zwischen der Spenderfolie (62) und dem Empfängersubstrat (12) umfasst.

4. Verfahren nach Anspruch 1, 2 oder 3, wobei das Richten der Impulse der Laserstrahlung das Festsetzen wenigstens eines Parameters der Laserimpulse auf der Grundlage der vorbestimmten Entfernung umfasst.

5. Verfahren nach einem der vorhergehenden Ansprüche und welches das Absetzen von zusätzlichem Spendermaterial (11) oben auf dem abgesetzten Spendermaterial (11) an der gegebenen Position umfasst, durch (i) erneutes Anordnen der Spenderfolie (62) bei der vorbestimmten Entfernung, ohne zusätzliche Impulse der Laserstrahlung anzuwenden, und (ii) Steigern des Abstandes zwischen der Spenderfolie (62) und dem Empfängersubstrat (12).

6. Verfahren nach einem der vorhergehenden Ansprüche und welches das Absetzen eines zusammenhängenden Musters des Spendermaterials (11) auf dem Empfängersubstrat (12) umfasst, durch Ausführen eines oder mehrerer von Folgendem:
räumliches Formen eines Strahls (43) der Laserstrahlung und
Richten eines oder mehrerer zusätzlicher Impulse der Laserstrahlung, so dass sie bei einem vorbestimmten Abstand von der gegebenen Position auf die Spenderfolie (62) auftreffen.

7. Verfahren nach einem der vorhergehenden Ansprüche, wobei das Richten der Impulse der Laserstrahlung Folgendes umfasst:
Gleitenlassen der Laserstrahlung, so dass sie an mehreren Punkten auf die Spenderfolie (62) auftrifft, oder
Aufspalten der Laserstrahlung in mehrere Strahlen (43), die an mehreren jeweiligen Punkten, die voneinander getrennt sind, auf die Spenderfolie (62) auftreffen.

8. Verfahren nach einem der vorhergehenden Ansprüche und das, vor dem letztendlichen Absetzen der Vorsprünge (72) auf dem Empfängersubstrat (12), das Formen der Vorsprünge (72) durch (i) Anordnen eines Hilfssubstrats (70) bei einer gegebenen Entfernung von der Spenderfolie (62), (ii) Formen der Vorsprünge (72) durch Steigern eines Abstandes zwischen der Spenderfolie (62) und dem Hilfssubstrat (70) und (iii) Entfernen des Hilfssubstrats (70) umfasst, wobei wahlweise das Hilfssubstrat (70) einen zugewiesenen Bereich des Empfängersubstrats (12) umfasst, wobei ferner wahlweise das Hilfssubstrat (70) ein Substrat umfasst, dass sich von dem Empfängersubstrat (12) unterscheidet.

9. Verfahren nach einem der vorhergehenden Ansprüche, wobei das Spendermaterial (11) ein äquivalentes Viskositätsniveau aufweist, das höher ist als 10 000 Zentipoise bei 25°C.

10. Verfahren nach einem der vorhergehenden Ansprüche, wobei das Richten der Impulse der Laserstrahlung das Formen eines geometrischen Musters von Punkten auf dem Empfängersubstrat (12), durch Richten der Impulse auf mehrere unterschiedliche Positionen auf der Spenderfolie (62) und Veranlassen der Bildung mehrerer Vorsprünge (72) an den mehreren Positionen, umfasst und das ferner, nach dem Formen der Vorsprünge (72), das Drucken des geometrischen Musters durch Steigern eines Abstandes zwischen der Spenderfolie (62) und dem Empfängersubstrat (12), um so die distalen Spitzen der Vorsprünge (72) von der Spenderfolie (62) zu lösen, wahlweise das Wiederholen des Druckens des geometrischen Musters ohne das Anwenden zusätzlicher Impulse der Laserstrahlung, umfasst.

11. Verfahren nach einem der vorhergehenden Ansprüche, wobei das Spendermaterial (11) ein gegebenes Material umfasst, dessen Viskosität unter Scherbeanspruchung abnimmt, wobei wahlweise die Scherbeanspruchung durch den einen oder die mehreren Impulse einer Laserstrahlung verursacht wird, die auf die Spenderfolie (62) auftreffen, wobei ferner wahlweise, als Reaktion auf die Beseitigung der Scherbeanspruchung, das Viskositätsniveau des gegebenen Materials nach einer Zeitverzögerung zwischen 100 Mikrosekunden und 100 Millisekunden zu seinem Niveau vor der Beanspruchung zurückkehrt, wobei noch ferner wahlweise das gegebene Material eine Form umfasst, die ausgewählt ist aus einer Liste, die aus einer Tinte, eine Paste, einem Gel und Dispersionen, die Teilchen umfassen, besteht.

12. Vorrichtung zum Absetzen von Material, wobei die Vorrichtung eine Positionierungsbaugruppe, eine optische Baugruppe und eine Steuereinheit (27), die den Betrieb der optischen Baugruppe (16) und der Positionierungsbaugruppe (18) nach dem Verfahren nach Anspruch 1 steuert, so dass:
die Positionierungsbaugruppe (18) dafür konfiguriert ist, eine Spenderfolie (62), die ein Spendermaterial (11) umfasst, bei einer vorbestimmten Entfernung von einem Empfängersubstrat (12) anzuordnen, wobei die Spenderfolie (62) zu dem Empfängersubstrat (12) hin zeigt, und
die optische Baugruppe (16) dafür konfiguriert ist, einen oder mehrere Impulse einer Laserstrahlung zu erzeugen und den einen oder mehreren Impulse zu richten, so dass sie an einer gegebenen Position auf die Spenderfolie (62) auftreffen, um so die Bildung eines Vorsprungs (72) zu veranlassen, der aus dem Spendermaterial (11) hergestellt ist, wobei eine distale Spitze des Vorsprungs (72) das Empfängersubstrat (12) berührt und sich auf demselben absetzt, während sich der Vorsprung (72) noch in Berührung mit der Spenderfolie (62) befindet,
wobei, nach dem Formen des Vorsprungs (72), die Positionierungsbaugruppe (18) dafür konfiguriert ist, einen Punkt des Spendermaterials (11) auf dem Empfängersubstrat (12) zu bilden, durch Steigern eines Abstandes zwischen der Spenderfolie (62) und dem Empfängersubstrat (12), um so die distale Spitze des Vorsprungs (72) von der Spenderfolie (62) zu lösen.

13. Vorrichtung nach Anspruch 12, wobei die Positionierungsbaugruppe (18) dafür konfiguriert ist, die Spenderfolie (62) nach dem Richten der Impulse der Laserstrahlung bei der vorbestimmten Entfernung anzuordnen und dabei den Abstand zu steigern, nachdem die distale Spitze des Vorsprungs (72) das Empfängersubstrat (12) berührt hat.

14. Vorrichtung nach Anspruch 12 oder 13, wobei die Positionierungsbaugruppe (18) dafür konfiguriert ist, eine Menge des abgesetzten Spendermaterials (11) durch Steuern des vorbestimmten Abstandes zwischen der Spenderfolie (62) und dem Empfängersubstrat (12) zu steuern.

15. Vorrichtung nach Anspruch 12, 13 oder 14, wobei die optische Baugruppe (16) dafür konfiguriert ist, wenigstens einen Parameter der Laserimpulse auf der Grundlage der vorbestimmten Entfernung festzusetzen.

## Revendications

1. Procédé pour déposer un matériau, comprenant :
le positionnement d'un film donneur (62) qui comprend un matériau donneur (11) à une distance prédéfinie d'un substrat accepteur (12), dans lequel le film donneur (62) fait face au substrat accepteur (12) ;
la direction d'une ou de plusieurs impulsion(s) d'un rayonnement laser de telle sorte qu'elle(s) arrive(nt) en incidence sur le film donneur (62) au niveau d'une localisation donnée de manière à ce qu'elle(s) induise(nt) la formation d'une protubérance (72) qui est réalisée à partir du matériau donneur (11), dans lequel une pointe distale de la protubérance (72) touche le substrat accepteur (12) et se dépose sur celui-ci tandis que la protubérance (72) est toujours en contact avec le film donneur (62) ; et
**caractérisé en ce qu'**il comprend également :
la formation d'un point du matériau donneur (11) sur le substrat accepteur (12) en augmentant une séparation entre le film donneur (62) et le substrat accepteur (12) de manière à détacher la pointe distale de la protubérance (72) vis-à-vis du film donneur (62).

2. Procédé selon la revendication 1, dans lequel le positionnement du film donneur (62) à la distance prédéfinie est mis en œuvre après la direction des impulsions du rayonnement laser, et dans lequel l'augmentation de la séparation est mise en œuvre après que la pointe distale de la protubérance (72) a touché le substrat accepteur (12).

3. Procédé selon la revendication 1 ou 2, et comprenant la commande d'une quantité du matériau donneur déposé (11) en commandant la distance prédéfinie entre le film donneur (62) et le substrat accepteur (12).

4. Procédé selon l'une quelconque des revendications 1, 2 ou 3, dans lequel la direction des impulsions du rayonnement laser comprend la définition d'au moins un paramètre des impulsions laser sur la base de la distance prédéfinie.

5. Procédé selon l'une quelconque des revendications qui précèdent, et comprenant le dépôt de matériau donneur additionnel (11) sur le sommet du matériau donneur déposé (11) au niveau de la localisation donnée en (i) repositionnant le film donneur (62) à la distance prédéfinie sans appliquer d'impulsions additionnelles du rayonnement laser et en (ii) augmentant la séparation entre le film donneur (62) et le substrat accepteur (12) à nouveau.

6. Procédé selon l'une quelconque des revendications qui précèdent, et comprenant le dépôt, sur le substrat accepteur (12), d'un motif contigu du matériau donneur (11) en réalisant une ou plusieurs des actions qui suivent :
la conformation spatiale d'un faisceau (43) du rayonnement laser ; et
la direction d'une ou de plusieurs impulsion(s) additionnelle(s) du rayonnement laser de telle sorte qu'elle(s) arrive(nt) en incidence sur le film donneur (62) selon un espacement prédéfini par rapport à la localisation donnée.

7. Procédé selon l'une quelconque des revendications qui précèdent, dans lequel la direction des impulsions du rayonnement laser comprend :
le balayage du rayonnement laser de telle sorte qu'il arrive en incidence sur le film donneur (62) au niveau de multiples points ; ou
la séparation du rayonnement laser selon de multiples faisceaux (43) qui arrivent en incidence sur le film donneur (62) au niveau de multiples localisations respectives qui sont séparées les unes des autres.

8. Procédé selon l'une quelconque des revendications qui précèdent, et comprenant, avant de finaliser le dépôt des protubérances (72) sur le substrat accepteur (12), la formation des protubérances (72) en (i) positionnant un substrat auxiliaire (70) à une distance donnée du film donneur (62), en (ii) conformant les protubérances (72) en augmentant une séparation entre le film donneur (62) et le substrat auxiliaire (70) et en (iii) enlevant le substrat auxiliaire (70), en option, le substrat auxiliaire (70) comprenant une aire surfacique attribuée du substrat accepteur (12), en outre en option, le substrat auxiliaire (70) comprenant un substrat qui est différent du substrat accepteur (12).

9. Procédé selon l'une quelconque des revendications qui précèdent, dans lequel le matériau donneur (11) présente un niveau de viscosité équivalent qui est supérieur à 10 000 centipoises à une température de 25 °C.

10. Procédé selon l'une quelconque des revendications qui précèdent, dans lequel la direction des impulsions du rayonnement laser comprend la formation d'un motif géométrique de points sur le substrat accepteur (12), en dirigeant les impulsions sur de multiples localisations différentes sur le film donneur (62) et en induisant la formation de multiples protubérances (72) au niveau des multiples localisations, et comprenant, après la formation des protubérances (72), l'impression du motif géométrique en augmentant une séparation entre le film donneur (62) et le substrat accepteur (12) de manière à détacher des pointes distales des protubérances (72) vis-à-vis du film donneur (62), en option, la répétition de l'impression du motif géométrique sans appliquer d'impulsions additionnelles du rayonnement laser.

11. Procédé selon l'une quelconque des revendications qui précèdent, dans lequel le matériau donneur (11) comprend un matériau donné dont la viscosité diminue sous une contrainte de cisaillement, en option, la contrainte de cisaillement est générée par les une ou plusieurs impulsions de rayonnement laser qui arrivent en incidence sur le film donneur (62), en outre en option, en réponse à la suppression de la contrainte de cisaillement, le niveau de viscosité du matériau donné revient à son niveau d'avant contrainte après un retard temporel entre 100 microsecondes et 100 millisecondes, encore en outre en option, le matériau donné présente une forme qui est sélectionnée au sein d'une liste qui est constituée par une encre, une pâte, un gel et des dispersions qui comprennent des particules.

12. Appareil pour déposer un matériau, l'appareil comprenant un assemblage de positionnement, un assemblage optique et une unité de commande (27) qui commande le fonctionnement de l'assemblage optique (16) et de l'assemblage de positionnement (18) selon le procédé selon la revendication 1 de sorte que :
l'assemblage de positionnement (18) est configuré de manière à ce qu'il positionne un film donneur (62) qui comprend un matériau donneur (11) à une distance prédéfinie d'un substrat accepteur (12), dans lequel le film donneur (62) fait face au substrat accepteur (12) ; et
l'assemblage optique (16) est configuré de manière à ce qu'il génère une ou plusieurs impulsion(s) d'un rayonnement laser et de manière à ce qu'il dirige les une ou plusieurs impulsions de telle sorte qu'elles arrivent en incidence sur le film donneur (62) au niveau d'une localisation donnée de manière à ce qu'elles induisent la formation d'une protubérance (72) qui est réalisée à partir du matériau donneur (11), dans lequel une pointe distale de la protubérance (72) touche le substrat accepteur (12) et se dépose sur celui-ci tandis que la protubérance (72) est toujours en contact avec le film donneur (62) ;
dans lequel, après la formation de la protubérance (72), l'assemblage de positionnement (18) est configuré de manière à ce qu'il forme un point du matériau donneur (11) sur le substrat accepteur (12) en augmentant une séparation entre le film donneur (62) et le substrat accepteur (12) de manière à détacher la pointe distale de la protubérance (72) vis-à-vis du film donneur (62).

13. Appareil selon la revendication 12, dans lequel l'assemblage de positionnement (18) est configuré de manière à ce qu'il positionne le film donneur (62) à la distance prédéfinie après la direction des impulsions du rayonnement laser, et de manière à ce qu'il augmente la séparation après que la pointe distale de la protubérance (72) a touché le substrat accepteur (12).

14. Appareil selon la revendication 12 ou 13, dans lequel l'assemblage de positionnement (18) est configuré de manière à ce qu'il commande une quantité du matériau donneur déposé (11) en commandant la distance prédéfinie entre le film donneur (62) et le substrat accepteur (12).

15. Appareil selon la revendication 12, 13 ou 14, dans lequel l'assemblage optique (16) est configuré de manière à ce qu'il définisse au moins un paramètre des impulsions laser sur la base de la distance prédéfinie.
